# DEMANDE DE BREVET EUROPEEN

(11) **EP 1 487 012 A2**
(43) Date de publication de la demande: **15.12.2004**
(21) Numéro de dépôt: 04291267.5
(22) Date de dépôt: 18.05.2004
(51) Int. Cl.: H01L 21/762

(54) **Procédé de réalisation de structure hétérogène et structure obtenue par un tel procédé**

(30) Priorité: 11.06.2003 FR 0307027
(71) Demandeur: S.O.I.Tec Silicon on Insulator Technologies, 38190 Bernin (FR)
(72) Inventeur: Martinez, Muriel, 38120 St Egreve (FR); Boussagol, Alice, 38190 Brignoud (FR)
(74) Mandataire: Joly, Jean-Jacques

(57) **Abrégé**

L'invention concerne un procédé de réalisation d'une couche d'un premier matériau sur un substrat, constitué d'un deuxième matériau, les deux matériaux ayant des coefficients de dilatation thermique différents, comportant :
- la sélection d'un premier et d'un deuxième substrats, le premier substrat étant constitué du premier matériau, le deuxième substrat étant constitué du deuxième matériau, ainsi que d'un troisième substrat en un matériau identique à l'un ou l'autre des premier et deuxième matériaux, ou constitué d'un matériau de coefficient de dilatation thermique voisin ou proche de celui de l'un ou l'autre des premier et deuxième matériaux,
- la réalisation d'un assemblage dans lequel les premier et deuxième substrats sont assemblés l'un contre l'autre, et le troisième substrat, est assemblé contre l'un des premier et deuxième substrats,
- la réalisation d'une fracture du premier substrat dans son épaisseur.

## Description

L'invention concerne le domaine des structures hétérogènes, associant deux substrats de coefficients de dilatation thermique différents.

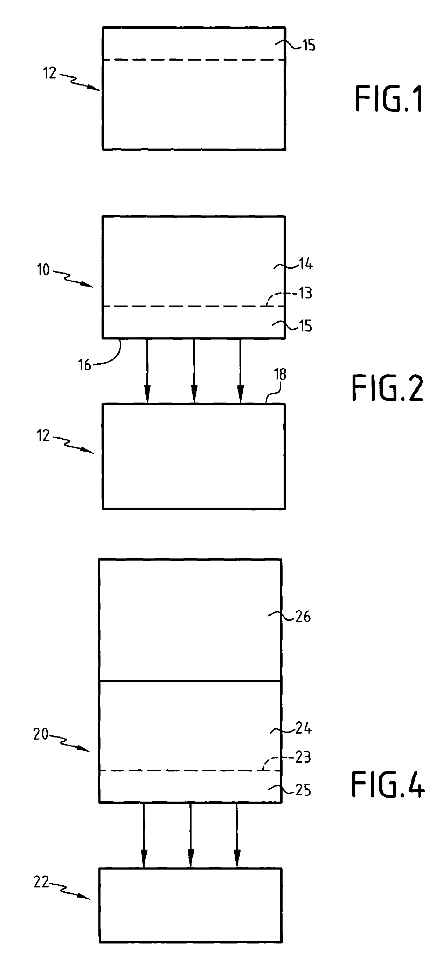

Une telle structure est représentée schématiquement sur la figure 1, comporte un substrat 12 ayant un premier coefficient de dilatation thermique et un film ou une couche 15 ayant un deuxième coefficient de dilatation thermique.

Un exemple d'une telle structure est le système quartz sur silicium, pouvant être utilisé dans des applications optiques, telles que la réalisation d'écrans.

Sont également concernés d'autres systèmes tels que, par exemple, le système silicium sur saphir ou silicium sur verre ou carbure de silicium sur verre ou germanium sur verre ou germanium sur silicium.

Le silicium a par exemple un coefficient de dilatation thermique de 3,59. 10⁻⁶/C, et le quartz 6.10⁻⁷/C.

Lors de l'assemblage de deux substrats de coefficients de dilatation thermique différents, par exemple différents d'au moins 10% ou 20% à température ambiante (20°C), ou lors de tout traitement ultérieur des deux substrats assemblés, des phases de montée en température peuvent avoir lieu, par exemple pour renforcer l'interface de collage.

Lorsque les substrats sont d'épaisseurs comparables ou sensiblement identiques ou voisines et ont un comportement de couche mince, les variations de comportement d'un des deux substrats par rapport à l'autre peuvent alors résulter en une cassure de l'un au moins des deux substrats, par un phénomène de relâchement de contraintes, et ce dès que la température atteint quelques centaines de degrés (par exemple une température comprise entre 200°C et 600°C).

D'une manière générale, des variations de température, par exemple comprises entre 200°C et 600°C, peuvent, du fait des différences de coefficient de dilatation thermique, provoquer des contraintes, mais aussi la délamination ou le détachement des substrats ou couches en présence, et/ou des déformations plastiques et/ou des fractures et/ou une cassure de l'un ou des substrats ou couches en présence.

Il se pose donc le problème de trouver un procédé permettant d'éviter ces effets dans une telle structure lors de telles phases d'exploration en température.

De manière connue, pour réaliser des systèmes tels que celui de la figure 1, on utilise actuellement diverses techniques.

Selon une première technique, illustrée sur la figure 2, une implantation ionique est d'abord réalisée dans un substrat 10, à partir duquel la couche 15 sera réalisée. Cette implantation forme une mince couche 13 fragilisée qui s'étend sensiblement parallèlement à la surface 16 du substrat 10.

Les deux substrats 10 et 12 ainsi préparés sont d'épaisseurs comparables ou voisines. Ils sont ensuite assemblés, face 16 contre face 18, par une technique de type « wafer bonding » (contact direct) ou par contact de type adhérent ou par collage moléculaire et/ou par collage anodique.

On effectue ensuite un prérecuit à température donnée et à budget thermique limite, inférieur au budget permettant de réaliser une fracture thermique du substrat 10.

Le budget thermique est en fait donné par le produit de la durée du traitement thermique par la température du traitement thermique.

On se place donc dans des conditions ne permettant pas de réaliser une fracture thermique du substrat 10.

Le détachement du substrat 10 est réalisé mécaniquement, par exemple à l'aide d'une lame qui apporte l'énergie supplémentaire nécessaire.

Selon une autre technique, après assemblage des deux substrats, un amincissement du substrat 10 est réalisé de manière mécanique et/ou chimique. L'amincissement mécanique est réalisé par rodage et polissage. L'amincissement chimique met en oeuvre un produit tel que le TMAH (Tétramethyl-Hydroxyde-Amonium).

Ces deux techniques ne permettent pas de récupérer et de pouvoir utiliser la partie 14 du substrat 10 qui est enlevée.

Selon encore une autre technique, il est possible de réaliser un dépôt anodique sur un substrat, par exemple un substrat de verre, utilisé en tant qu'anode. Ce procédé permet un collage à une température donnée qui permet ensuite d'activer le processus de transfert à des températures plus basses que celle requise par le collage moléculaire et éliminer la contrainte thermique dans les couches.

Ces trois techniques ont l'inconvénient majeur de complexifier le procédé, d'en augmenter le coût, sans pour autant permettre l'obtention de couches de qualité suffisante.

Il se pose donc le problème de pouvoir réaliser, à partir d'un premier substrat, un film mince sur un second substrat, ce film ayant une épaisseur par exemple comprise entre 50 nm et 500 nm, les deux substrats présentant des coefficients de dilatation thermique différents.

Ce problème se pose notamment pour des assemblages de type silicium sur quartz ou sur verre ou sur saphir, ou germanium sur silicium, ou germanium sur verre ou carbure de silicium SiC sur quartz ou sur verre.

### Exposé de l'invention

L'invention concerne un procédé de réalisation d'une couche d'un premier matériau sur un substrat constitué d'un deuxième matériau, les deux matériaux ayant des coefficients de dilatation thermique différents, comportant :
- la sélection d'un premier et d'un deuxième substrats, le premier substrat étant constitué du premier matériau, le deuxième substrat étant constitué du deuxième matériau, ainsi que la sélection d'un troisième substrat en un matériau identique à l'un ou l'autre des premier et deuxième matériaux, ou constitué d'un matériau de coefficient de dilatation thermique voisin ou proche de celui de l'un ou l'autre des premier et deuxième matériaux,
- la réalisation d'un assemblage dans lequel les premier et deuxième substrats sont assemblés l'un contre l'autre, et le troisième substrat est assemblé contre l'un des premier et deuxième substrats.
- la réalisation d'une fracture du premier substrat.

Ce procédé permet de réaliser une couche du premier matériau sur le substrat du second matériau, le substrat constitué du troisième matériau étant ensuite éliminé.

La fracture réalisée dans l'épaisseur du premier substrat peut être une fracture de type thermique, par exemple à température comprise entre 250°C et 600°C. En outre, il est possible de réaliser une étape de montée en température, par exemple, jusqu'à plus de 900°C, pour renforcer l'assemblage des premier et deuxième substrats.

L'utilisation du troisième substrat sur l'un ou l'autre des deux substrats permet de réduire de manière importante la courbure engendrée du fait des différences des coefficients de dilatation thermique entre le premier et le deuxième substrat. Ceci concerne, notamment, les courbures engendrées lors d'une montée en température pour réaliser la fracture des deux substrats ou pour améliorer la qualité du contact entre les premier et deuxième substrats.

Il est possible de positionner le troisième substrat contre le premier substrat, ou contre le deuxième substrat.

Ainsi, dans un système silicium - quartz, on utilisera un troisième substrat, ou une plaque en quartz, positionnée du côté du quartz.

De préférence, le troisième substrat a une épaisseur telle que la somme des épaisseurs du troisième substrat et du substrat contre lequel il est positionné soit supérieure à l'épaisseur du substrat contre lequel il n'est pas positionné. Si le troisième substrat, et celui contre lequel il est positionné, sont en quartz, on pourra utiliser une épaisseur totale comprise entre 700µm et 1200µm ou entre 1800µm et 2500µm.

L'invention concerne donc également un procédé de réalisation d'une couche d'un premier matériau sur un substrat, constitué d'un deuxième matériau, les deux matériaux ayant des coefficients de dilatation thermique différents, comportant :
- la sélection d'un premier et d'un second substrats, le premier substrat étant constitué du premier matériau et le second substrat étant constitué du second matériau,
- la formation, sur l'un ou l'autre des deux substrats, avant ou après assemblage de ces deux substrats, d'une couche en un matériau identique à l'un ou l'autre des deux matériaux, ou constitué d'un matériau de coefficient de dilatation thermique voisin ou proche de celui de l'un ou l'autre des deux matériaux,
- l'assemblage du premier et du second substrats,
- la réalisation d'une fracture du premier substrat.

### Brève description des figures

- la figure 1 représente une structure hétérogène,
- la figure 2 décrit une technique connue de réalisation de couche sur un substrat, par procédé de fracture de substrat,
- les figures 3A à 3C décrivent un mode de réalisation d'un procédé selon l'invention,
- la figure 4 représente une variante de ce mode de réalisation de l'invention.

### Exposé détaillé de mode de réalisation de l'invention

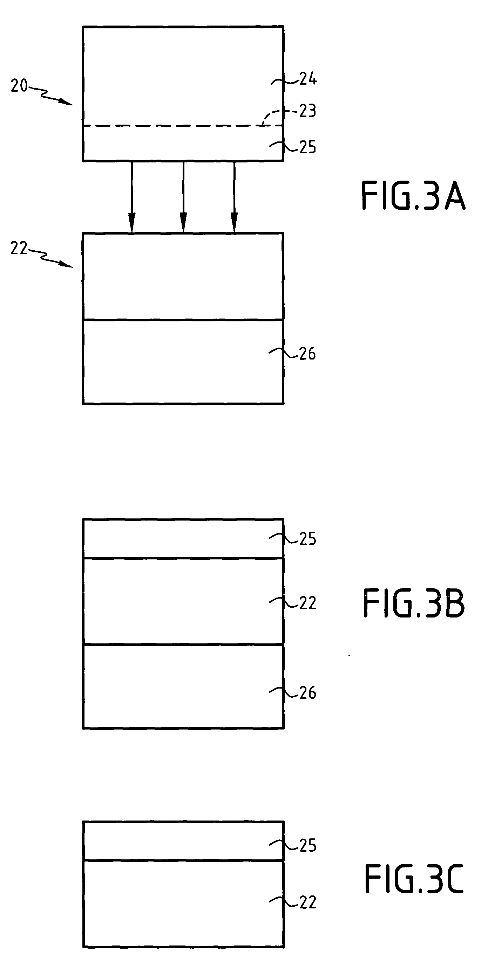

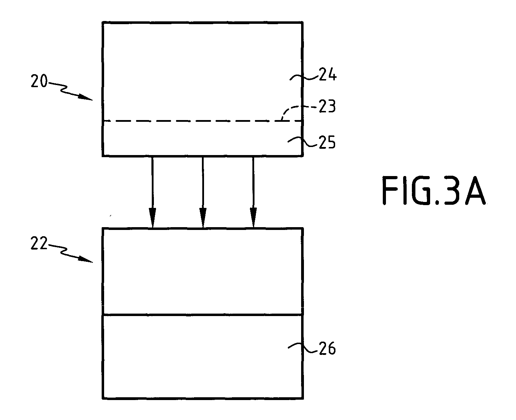

Un premier exemple de réalisation de l'invention va être donné en liaison avec les figures 3A à 3C.

Sur la figure 3A, la référence 20 désigne un premier substrat, en un premier matériau, et la référence 22 un deuxième substrat, (d'épaisseur comprise entre 500 µm et 1200 µm) en un deuxième matériau, de coefficient de dilatation thermique différent du premier, la différence relative entre les deux coefficients étant par exemple supérieure ou égale à environ 10% ou 20% à température ambiante.

Selon un exemple, le premier substrat est en silicium et le deuxième est en quartz. On peut aussi avoir un système silicium-saphir ou silicium-verre.

Selon une première étape, (figure 3A), une implantation atomique ou ionique est réalisée dans le substrat 20, formant une couche 23 constituant une zone de fragilisation ou de fracture. Le volume du substrat 20 est donc séparé en une région inférieure 25 (d'épaisseur comprise entre 50 nm et 500 nm) destinée à constituer la couche à former sur le matériau 22, et une région supérieure 24 constituant la masse du substrat 20. En général, l'implantation est une implantation d'hydrogène, mais peut aussi être réalisée à l'aide d'autres espèces, ou encore avec une co-implantation de deux espèces, par exemple hydrogène/hélium.

Une couche ou un plan 23 de fragilisation ou de fracture peut aussi être réalisé par formation d'une couche poreuse, comme par exemple décrit dans l'article de K. Sataguchi et al. « ELTRAN by Splitting Porous Si Layers », Proceedings of the 9th Int. Symposium on Silicon-on-Insulator Tech. and Device, 99-3, The Electrochemical Society, Seattle, p.117 - 121 (1999).

Les deux substrats 20 et 22 ainsi préparés sont ensuite assemblés, face 16 contre face 18, par une technique de type « wafer bonding » (assemblage de tranches par toute technique connue dans le domaine de la microélectronique) ou par contact de type adhérent ou par collage moléculaire ou par un procédé chimique (on active une des deux surfaces de manière à la rendre hydrophile ou hydrophobe), ou par activation de surface par polissage. Les deux substrats sont mis en contact simple, assisté mécaniquement pour réduire la distance entre les deux substrats et amorcer l'adhésion. De telles techniques sont par exemple décrites dans l'ouvrage de Q.Y. Tong et U. Gösele « Semiconductor Wafer Bonding » (Science and Technology), Wiley Interscience Publications.

Le substrat 22 est ensuite mis en contact et assemblé avec un substrat 26, d'épaisseur telle que la somme des épaisseurs des substrats 22 et 26 soit supérieure à l'épaisseur du substrat 20. L'assemblage a lieu par exemple par adhésion moléculaire ou bien à l'aide de colle.

Le coefficient de dilatation de ce substrat 26 est proche de celui du substrat 22, la différence relative entre leurs coefficients de dilatation thermique étant inférieure à 10% à température ambiante. Selon un exemple, le substrat 26 est en un matériau identique à celui du substrat 22, tous deux sont par exemple en quartz.

Après assemblage des substrats 20 et 22, la partie 24 du substrat 20 est éliminée, par exemple par un traitement thermique et/ou par application de contrainte mécanique (lame ou jet d'eau sous pression) provoquant une fracture le long du plan de fragilisation 23. Le traitement thermique met en oeuvre une montée à une température par exemple comprise entre 350°C et 500°C ou 650°C.

Le substrat 26 permet de maintenir le système plan et évite les courbures des deux substrats 20 et 22, malgré les différences entre les coefficients de dilatation thermique du substrat 20 et du substrat 22 lors de cette montée en température, et malgré le fait que la couche 25 absorbe alors plus de contraintes qu'en l'absence de contre-plaque 26 de quartz.

En l'absence de ce substrat 26, les deux substrats 20, 22 étant initialement d'épaisseurs comparables, et ayant des coefficients de dilatation thermiques différents, la structure assemblée couche mince 25-substrat 22 risquerait de casser lors de la réalisation du transfert de cette couche mince 25 sur ce substrat 22. En outre, il y aurait un risque de décollement à l'interface de collage entre les deux substrats 20 et 22, risque de décollement lui aussi lié aux contraintes et aux courbures induites du fait des différences de coefficients de dilatation thermique.

Ces risques sont évités du fait de la présence du substrat 26, et ce malgré la présence de contraintes encore importantes dans le substrat 22 et/ou la couche 25.

La structure obtenue est alors celle de la fig. 3B.

Le substrat 26 est ensuite séparé de l'ensemble constitué par la couche 25 déposée ou formée sur le substrat 22 (figure 3C).

Si l'assemblage des substrats 26 et 22 a été réalisé par adhésion moléculaire, leur séparation peut être réalisée grâce à l'insertion d'une lame à l'interface des deux substrats. S'ils sont assemblés par colle on pourra utiliser un solvant pour les séparer.

La partie 24 du substrat 20 peut ensuite être récupérée pour être réutilisée, et ceci bien que la structure initiale soit hétérogène.

En outre, la couche 25 présente des qualités (absence de plan de glissements ou de dislocations dans le matériau) supérieures à celles des couches obtenues par les techniques connues déjà décrites.

Selon l'invention, il est donc possible de mettre en oeuvre, pour obtenir de telles structures, une technique de type « smart cut » ou de fracture de substrat.

Selon une variante, la couche 25 comporte à sa surface une mince couche d'oxyde, par exemple d'épaisseur comprise entre 50 nm et 400 nm. La fonction du substrat 26 reste similaire à ce qui a été décrit ci-dessus.

Plus généralement, il peut y avoir une ou plusieurs couches intermédiaires insérées entre les substrats 20 et 22, ces couches intermédiaires pouvant se trouver sur le substrat 20 ou le substrat 22.

La figure 4 représente une variante, dans laquelle le substrat 26 est positionné (par exemple par adhésion moléculaire ou à l'aide de colle) sur le substrat 20 avant assemblage avec le substrat 22. Là encore, le substrat 26 évite les dilatations et les déformations dues aux différences de coefficient de dilatation thermique entre les substrats 20 et 22. La somme des épaisseurs des substrats 26 et 20 est de préférence supérieure ou largement supérieure à celle du substrat 22. Les coefficients de dilatation thermique des substrats 20 et 26 sont proches l'une de l'autre, au sens déjà indiqué ci-dessus (écart relatif inférieur à 10%).

Après réalisation, de la manière décrite ci-dessus, de la cassure du substrat 20, au niveau du plan de fracture 23, le substrat 26 et la partie 24 du substrat 20 sont retirés. Il en résulte alors une structure identique à celle de la figure 3C.

Selon une variante, le substrat 26 présente un coefficient de dilatation proche identique à celui du substrat 20. Par exemple, dans le cas d'un assemblage silicium (substrat 20) - saphir (substrat 22) on utilisera un substrat 26 ayant un coefficient de dilatation identique à celui du silicium. Le substrat 26 sera par exemple lui-même un substrat en silicium et sera déposé du côté du substrat 20.

Dans le cas du premier mode de réalisation (figure 3A), l'utilisation de la plaque 26 permet de mettre en oeuvre un substrat 22 d'épaisseur inférieure aux épaisseurs habituelles.

Ainsi, classiquement, un substrat 22 en quartz d'épaisseur voisine ou égale à 800 µm subit une cassure lors du traitement thermique permettant de transférer la couche 25 du substrat 20. Il faut alors utiliser des substrats d'épaisseur sensiblement égale à 1000 µm, ou plus.

L'invention permet, au contraire, d'utiliser des substrats d'épaisseur plus faible, inférieure à 800µm, notamment comprise entre 500 µm et 800 µm, par exemple des substrats de quartz d'épaisseur 525µ.

## Revendications

1. Procédé de réalisation d'une couche (25) d'un premier matériau sur un substrat (22), constitué d'un deuxième matériau, les deux matériaux ayant des coefficients de dilatation thermique différents, comportant :
la sélection d'un premier et d'un deuxième substrats (20, 22), le premier substrat étant constitué du premier matériau, le deuxième substrat étant constitué du deuxième matériau, ainsi que d'un troisième substrat (26) en un matériau identique à l'un ou l'autre des premier et deuxième matériaux, ou constitué d'un matériau de coefficient de dilatation thermique voisin ou proche de celui de l'un ou l'autre des premier et deuxième matériaux,
la réalisation d'un assemblage dans lequel les premier et deuxième substrats sont assemblés l'un contre l'autre, et le troisième substrat, est assemblé contre l'un des premier et deuxième substrats,
la réalisation d'une fracture du premier substrat dans son épaisseur.

2. Procédé selon la revendication 1, l'assemblage des premier et deuxième substrats étant réalisé après assemblage de l'un de ces deux substrats avec le troisième substrat.

3. Procédé selon la revendication 1, l'assemblage des premier et deuxième substrats étant réalisé avant assemblage de l'un de ces deux substrats avec le troisième substrat.

4. Procédé selon l'une des revendications 1 à 3, une couche fragilisée (23) étant formée dans le premier substrat.

5. Procédé selon la revendication 4, la couche fragilisée étant réalisée par implantation atomique ou ionique ou par formation d'une couche de Si poreux.

6. Procédé selon la revendication 5, la couche fragilisée étant réalisée par implantation atomique ou ionique et les ions implantés étant des ions hydrogène ou un mélange d'ions hydrogène et d'ions hélium.

7. Procédé selon l'une des revendications 1 à 6, la fracture du premier substrat étant réalisée à une température comprise entre 250°C et 600°C.

8. Procédé selon l'une des revendications 1 à 7, l'assemblage des premier et deuxième substrats étant réalisé par collage de type adhérent ou par collage moléculaire.

9. Procédé selon l'une des revendications 1 à 8, comportant en outre une étape de montée en température pour renforcer une interface d'assemblage des premier et deuxième substrats.

10. Procédé selon l'une des revendications 1 à 9, le premier substrat étant en un matériau semi-conducteur.

11. Procédé selon l'une des revendications 1 à 10, le deuxième substrat ayant une épaisseur comprise entre 500 µm et 800 µm.

12. Procédé selon l'une des revendications 1 à 11, le troisième substrat ayant une épaisseur comprise entre 700 µm et 1200 µm.

13. Procédé selon l'une des revendications 1 à 12, la couche de premier matériau et le substrat constitué par le deuxième matériau formant un assemblage silicium sur quartz ou sur verre ou sur saphir, ou germanium sur silicium, ou germanium sur verre ou carbure de silicium SiC sur quartz ou sur verre.

14. Procédé selon l'une des revendications 1 à 12, le premier matériau étant le silicium, le deuxième et le troisième matériaux étant du quartz.
